# EUROPEAN PATENT SPECIFICATION

(11) **EP 3 460 842 B1**
(45) Date of publication and mention of the grant of the patent: **16.03.2022**
(21) Application number: 17192391.5
(22) Date of filing: 21.09.2017
(51) Int. Cl.: H01L 23/522, H01L 23/48, H01L 21/822, H01L 27/06

(54) **SHIELDING IN AN INTEGRATED CIRCUIT**
ABSCHIRMUNG EINER INTEGRIERTEN SCHALTUNG
BLINDAGE DANS UN CIRCUIT INTÉGRÉ

(43) Date of publication of application: 27.03.2019
(73) Proprietor: IMEC vzw, 3001 Leuven (BE); Vrije Universiteit Brussel, 1050 Brussel (BE)
(72) Inventor: COLLAERT, Nadine, 3001 Leuven (BE); PARVAIS, Bertrand, 3001 Leuven (BE); VAN LIEMPD, Barend Wilhelmus Marinus, 3001 Leuven (BE)
(74) Representative: DenK iP bv

(56) References cited:
- WO-A1-2016/022435
- WO-A1-2016/114941
- US-A- 5 196 920
- US-A1- 2007 262 422
- US-A1- 2008 073 747
- US-A1- 2010 078 779
- US-A1- 2013 181 349
- US-B1- 9 755 029

## Description

### Technical field of the invention

The present invention relates to the field of integrated circuits and relates in particular to integrated circuits comprising electromagnetically shielded transistors.

### Background of the invention

In integrated circuits, there are often undesired signal losses or nonlinearities in transistors, for example, due to interference with surrounding components (e.g. other semiconductor devices, such as other transistors, or the substrate).

This is especially relevant when sequential or monolithic 3D semiconductor processing is used, which is a technology that, among others, enables the co-integration of radio-frequency (RF) devices with advanced complementary metal oxide semiconductor (CMOS) devices. Often, the RF devices are integrated on top of the advanced CMOS. For example, after processing of the advanced CMOS up to the middle-of-line (MOL) or back-end-of-line (BEOL), the RF devices are stacked on top of the CMOS by using layer transfer and subsequent processing. This allows to reduce the density of semiconductor devices by moving the large RF devices to the top layers and at the same time allows to optimize the RF devices, which need a quite dissimilar processing from the bottom CMOS. Nevertheless, undesirable signal losses and coupling that can occur with the underlying devices and/or substrate remain, and may even increase as the sources of interference are now more 3D oriented as opposed to 2D.

Documents WO2016/114941, US2013/181349, US5196920 and US2007/262422 represent prior art disclosing shielding structures for shielding components from sources of interference.

There is thus still a need in the art to improve upon some or all of the issues outlined above.

### Summary of the invention

It is an object of the present invention to provide good electromagnetic shielding of transistors in an integrated circuit. The above objective is accomplished by a device as recited in claim 1 md a method as recited in claim 13 according to the present invention.

It is an advantage of embodiments of the present invention that the propagation of the transistor signal outside of the normal signal path (e.g. outside of the channel, in the substrate) may be low.

It is an advantage of embodiments of the present invention that the transistor signal may show a high degree of linearity.

It is an advantage of embodiments of the present invention that the transistor may exhibit limited signal losses.

It is an advantage of embodiments of the present invention that cross-talk between the transistor and other components of the integrated circuit may be low.

It is an advantage of embodiments of the present invention that the integrated circuit may have a high circuit performance, such as a high signal to noise ratio.

In a first aspect, the present invention relates to an integrated circuit as recited in claim 1.

In a second aspect, the present invention relates to a method for forming an integrated circuit comprising an electromagnetically shielded second transistor as recited in claim 13.

Particular and preferred aspects of the invention are set out in the accompanying independent and dependent claims. Features from the dependent claims may be combined with features of the independent claims and with features of other dependent claims as appropriate and not merely as explicitly set out in the claims.

Although there has been constant improvement, change and evolution of devices in this field, the present concepts are believed to represent substantial new and novel improvements, including departures from prior practices, resulting in the provision of more efficient, stable and reliable devices of this nature.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

### Brief description of the drawings

Fig. 1 is a schematic representation of a first integrated circuit (IC) programmed in the simulations of example 1.
Fig. 2 shows schematic representations of a perspective view of two ICs programmed in the simulations of example 1 and representing comparative examples.
Fig. 3 shows a schematic representation of a perspective view of an IC programmed in the simulations of example 1 and corresponding to an IC in accordance with the present invention.
Fig. 4 shows simulation results, in accordance with example 1, for a first (comparative, circles), second (comparative, triangles) and third (embodiment, asterisks) IC.
Fig. 5 is a schematic representation of vertical cross-sections for several steps in the formation of an IC, according to a first exemplary embodiment of the present invention.
Fig. 6 is a schematic representation of vertical cross-sections of intermediate structures in the formation of an IC, according to a second exemplary embodiment of the present invention.
Fig. 7 is a schematic representation of a vertical cross-section of an IC, according to a third exemplary embodiment of the present invention.
Fig. 8 is a schematic representation of a vertical cross-section of an IC, according to a fourth exemplary embodiment of the present invention.
Fig. 9 is a schematic representation of a vertical cross-section of an IC, according to a fifth exemplary embodiment of the present invention.
Fig. 10 is a schematic representation of a perspective view of a shielding structure, according to embodiments of the present invention.
Fig. 11 is a flowchart of a method in accordance with an embodiment of the present invention.
In the different figures, the same reference signs refer to the same or analogous elements.

### Description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second, third and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein. For instance, a second layer does not imply the presence of a first layer.

Moreover, the terms top, bottom, over, under and the like in the description and the claims are used for descriptive purposes and not necessarily for describing relative positions. It is to be understood that the terms so used are interchangeable with their antonyms under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Similarly, it is to be noticed that the term "coupled", also used in the claims, should not be interpreted as being restricted to direct connections only. The terms "coupled" and "connected", along with their derivatives, may be used. It should be understood that these terms are not intended as synonyms for each other. Thus, the scope of the expression "a device A coupled to a device B" should not be limited to devices or systems wherein an output of device A is directly connected to an input of device B. It means that there exists a path between an output of A and an input of B which may be a path including other devices or means. "Coupled" may mean that two or more elements are either in direct physical or electrical contact, or that two or more elements are not in direct contact with each other but yet still co-operate or interact with each other.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly, it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

Furthermore, some of the embodiments are described herein as a method or combination of elements of a method that can be implemented by a processor of a computer system or by other means of carrying out the function. Thus, a processor with the necessary instructions for carrying out such a method or element of a method forms a means for carrying out the method or element of a method. Furthermore, an element described herein of an apparatus embodiment is an example of a means for carrying out the function performed by the element for the purpose of carrying out the invention.

In the description provided herein, numerous specific details are set forth. However, it is understood that embodiments of the invention may be practiced without these specific details. In other instances, well-known methods, structures, and techniques have not been shown in detail in order not to obscure an understanding of this description.

Reference will be made to transistors. These are devices having a first main electrode such as a drain, a second main electrode such as a source and a control electrode such as a gate for controlling the flow of electrical charges between the first and second main electrodes. It will be clear to a person skilled in the art that the present invention is also applicable to similar devices that can be configured in any transistor technology, including for example, but not limited thereto, CMOS, BICMOS, Bipolar and SiGe BICMOS technology.

The following terms are provided solely to aid in the understanding of the invention.

As used herein, and unless otherwise specified, an integrated circuit is a circuit of semiconductor devices (e.g. transistors, resistors and capacitors) constructed on a single bottom substrate in the form of a semiconductor wafer or chip, in which the components are interconnected to perform one or more given functions. This includes three-dimensional integrated circuits (3D ICs), i.e. integrated circuits comprising a plurality of overlying layers (e.g. a plurality of semiconductor wafers or dies) having each one or more semiconductor devices therein, the manufacture of which may involve bonding one or more additional semiconductor wafers or dies onto the single bottom substrate; nevertheless, these 3D ICs are thus still constructed on the single bottom substrate.

As used herein, and unless otherwise specified, an 'electrically conductive entity' or a 'trap-rich entity' is understood to be an entity made up of an electrically conductive material or a trap-rich material, respectively. The term 'entity' here can, for example, be replaced by any of an electromagnetic shielding structure, one of its sides (i.e. the bottom, lateral sides and top, if present) a shielding element, etc.

As used herein, and unless otherwise specified, when a lateral side is said to border the second transistor, it is meant that the lateral side stands adjacent to the second transistor. In particular, there may be no component between the lateral side and the second transistor. The distance between the lateral side and the second component is not very important. This distance may, for instance, be 10 µm or less or 2 µm or less.

In a first aspect, an example relates to an integrated circuit, comprising:
a host substrate;
optionally, a first layer overlaying the host substrate, the first layer optionally comprising a first transistor;
a second layer overlaying the host substrate and the first layer, if present, the second layer comprising a second transistor; and
an electromagnetic shielding structure shielding the second transistor from electromagnetic fields, comprising
a bottom underlying the second transistor and comprised in the host substrate, the first layer, if present, or the second layer,
one or more lateral sides laterally bordering the second transistor, and
optionally, a top overlaying the second transistor;
wherein the bottom, each of the one or more lateral sides and, if present, the top each comprise at least one shielding element independently made up of either an electrically conductive material or a trap-rich material.

By way of their makeup and fabrication, some embodiments of the integrated circuit may also be referred to as three-dimensional (3D), sequential or monolithic semiconductor devices, or as a combination thereof (e.g. as 3D sequential semiconductor devices).

The host substrate may, in general, be any substrate suitable for use in an integrated circuit, such as a semiconductor substrate (e.g. a Si wafer) or a semiconductor-on-insulator (SOI) (e.g. a Si-on-insulator or Ge-on-insulator substrate). In the case of an SOI, the top semiconductor layer may typically be seen as part of the first or the second layer of the present invention and thus not part of the host substrate as such (which is the bottom Si or Ge wafer). The host substrate may be a source of electromagnetic fields from which the second transistor is to be shielded.

The first layer, when present, may consist in one or more sub-layers.

The second layer may consist in one or more sub-layers.

The terms "first layer" and "second layer" are used to make clear that the second transistor is present at a higher position than the first transistor along the height of the integrated circuit.

The first layer, when present, is a layer optionally comprising one or more semiconductor devices, such as a first transistor or a plurality of first transistors. The first layer may comprise a first dielectric layer. The one or more semiconductor devices (e.g. first transistors) may, for example, be embedded in the first dielectric layer.

In the present invention, the first layer may also be referred to as a first tier or as a first stratum. The first layer may comprise one or more sources of electromagnetic fields (e.g. one or more semiconductor devices) from which a second transistor is to be shielded.

The first transistor, if present, may, for example, be an analog transistor or a digital transistor. The transistor may, for example, be a complementary metal oxide semiconductor (CMOS) transistor, such as a planar transistor, a fin field-effect transistor (FinFET), a gate-all-around (GAA) transistor or a vertical field-effect transistor (VFET). The first transistor may be a digital transistor.

The second layer is a layer comprising one or more second transistors and may comprise further semiconductor devices. The second layer may comprise a second dielectric layer. The one or more second transistors may, for example, be embedded in the second dielectric layer. In the present invention, the second layer may also be referred to as a second tier or as a second stratum. Most typically, at least one of the second transistors in the second layer is a transistor for which there is a desire to shield it from electromagnetic fields, such as fields coming from the first layer or from the host substrate. In embodiments, the at least one second transistor is shielded from electromagnetic fields, e.g. originating from the first layer or from the host substrate. In embodiments, the second layer may comprise a plurality of second transistors, one or more of which are enclosed by an electromagnetic shielding structure. In embodiments, one or more of the second transistors in the second layer may not be enclosed by an electromagnetic shielding structure.

In embodiments, the second transistor may be adapted for radio frequency (RF), logic or mixed-signal applications. The second transistor may, for example, be a planar (e.g. Si planar) transistor, a high-electron-mobility transistor (HEMT) (e.g. III-V HEMT), a metal-oxide-semiconductor field-effect transistor (MOSFET) (e.g. a III-V MOSFET) or a bipolar transistor. The second transistor may be an analog transistor or a digital transistor. Embodiments of the present invention may be particularly advantageous when integrated into the front-end module (FEM) of e.g. an RF device; as the linearity of the components is a key element in FEM, said linearity being improved by the present invention. The FEM is the part of the radio situated between the antenna and transceiver chip, typically including switches, filter, and power amplifier.

In a particular embodiment, the first transistor may be a digital transistor and the second transistor may be an analog transistor.

At least the bottom of the electromagnetic shielding structure, and preferably the whole of the electromagnetic shielding structure, is present within the integrated circuit; i.e. the electromagnetic shielding structure encloses one or more second transistors, without enclosing the integrated circuit as a whole. When it is said that the electromagnetic shielding structure encloses an entity, it is meant that at least the bottom underlays the entity and the lateral sides laterally border and preferably surround the entity. The presence of the top is thus not required in order to consider the entity as being enclosed. In embodiments, a distance between the second transistor and each of:
the bottom,
the lateral sides, and
if present, the top,
may be smaller than 10 µm. For instance, this distance may be from 100 nm to 10 µm or from 200 nm to 2 µm. A relatively small distance is preferred to minimize area (especially in low-frequency applications) while a relatively large distance is preferred for high-frequency applications to reduce the effect of the parasitic capacitance made by the shield. In embodiments, the electromagnetic shielding structure may have a width, a length and/or a height of from 100 nm to 100 µm, preferably from 100 nm to 20 µm. In particular, the width and the length may preferably be smaller than the height. The width and the length may, for instance, be from 1 µm to 100 µm, preferably from 1 µm to 20µm. The height may, for instance, be from 100 nm to 20 µm, preferably from 100 nm to 1µm. In embodiments, an electromagnetic shielding structure may enclose a single second transistor. In embodiments, a single electromagnetic shielding structure may enclose a plurality of second transistors. In embodiments, a plurality of electromagnetic shielding structures may enclose a plurality of second transistors. A plurality of electromagnetic shielding structures may share at least one shielding element (e.g. they may share a side).

It was surprisingly found within the present invention that enclosing a second transistor in the electromagnetic shielding structure comprising an electrically conductive material and/or a trap-rich material advantageously improves the shielding of the second transistor with respect to electromagnetic fields when compared to a situation when only a conductive or trap-rich bottom is interposed between the second transistor and a first transistor or the substrate. To aid in the understanding of the present invention, the electromagnetic shielding structure, particularly when made up of an electrically conductive material, may be seen as a Faraday or Faraday-like cage around the second transistor. In embodiments, the shielding (i.e. electromagnetic isolation) of the second transistor may be improved by at least 1 dB, preferably at least 10 dB compared to the same second transistor in absence of the electromagnetic shielding structure. The thickness of a side (i.e. the height of a top or a bottom, or the width of a lateral side) of the electromagnetic shielding structure may determine the frequencies of the electromagnetic field that it is shielded from. This thickness may, for instance, be chosen in function of the frequencies from which one desires the transistor to be shielded, of the target degree of isolation, and/or of the material used. In embodiments, the thickness of a side of the electromagnetic shielding structure may be from 10 nm to 1 µm.

A higher degree of electromagnetic shielding of the second transistor advantageously improves the electronic characteristics of the second transistor, such as reducing the signal integrity, increasing the signal linearity and reducing the signal losses of the electrical signal. Improving the electronic characteristics advantageously leads to improved circuit performance.

Since sources of electromagnetic fields, which may interfere with the second transistor, are typically found in layers underlying the second transistor (e.g. in the first layer or in the host substrate) or found adjacent the second transistor (i.e. in the second layer itself), the additional shielding provided by the top may be limited; as such, the top may, in general, be optional. Nevertheless, particularly when additional semiconductor devices are present above the second transistor (e.g. in a third layer overlaying the second layer), the presence of the top may be desired.

In embodiments, the electromagnetic shielding structure may enclose a portion of a Si or Ge wafer, such as a portion of the host substrate or a portion of a wafer overlaying the host substrate (e.g. in a 3D integrated circuit). Since such a substrate may be a source of electromagnetic fields and since the electromagnetic shielding structure does not typically offer a good electromagnetic shielding between any second transistor enclosed therein and any portion of a substrate enclosed therein, the size of said portion is advantageously minimized. For example, when the bottom is present in the host substrate, it is preferably located towards the top of the host substrate, and not towards the bottom of the host substrate. In embodiments, a distance between a top of the host substrate and the bottom of the electromagnetic shielding structure may be 1 µm or less. Likewise, when the integrated circuit comprises a further substrate overlaying the host substrate and a portion of the further substrate is enclosed by the electromagnetic shielding structure, said further substrate may advantageously be relatively thin. For instance, it may be from 100 nm to 500 µm. All other things being equal, thinner is better, but mechanical constraints may push for a thickness in the higher part of the range.

In embodiments, the electrically conductive material may have a conductivity of at least 1 × 10⁵ S/m. The electrical conductivity of the electrically conductive material may be the one measured on a bulk sample of the material, or the one found in standard tables or literature. It may be assumed that the value of the conductivity obtained in this way is sufficiently similar to the in-situ value. In embodiments, the electrically conductive material may be a metallic material, such as a material selected from copper, tungsten, and cobalt.

In embodiments, the trap-rich material (i.e. a material having a high density of trap states) has a trap density of at least 10²² cm⁻³. The trap density of the trap-rich material may be the one measured on a bulk sample of the material (i.e. after having undergone the same or similar treatment, such as a corresponding level of implantation). It may be assumed that the value of the trap density obtained in this way is sufficiently similar to the in-situ value. In embodiments, the trap-rich material is selected from trap-rich polycrystalline silicon and trap-rich amorphous silicon.

In embodiments, each of the shielding elements may be independently selected from a sheet and a line. The sheet may be a structure with three perpendicular dimensions, wherein a first dimension measures from 1 nm to 3 µm, preferably from 10 nm to 3 µm, such as from 10 nm to 100 nm, and wherein a second and third dimension are at least 2 times larger than the first dimension, preferably at least 5 times, yet more preferably at least 10 times. The sheet may, for example, be a thin layer. The line may be a structure with three perpendicular dimensions, wherein a first dimension and second dimension measure from 1 nm to 3 µm, preferably from 10 nm to 3 µm, such as from 10 nm to 100 nm, and wherein a third dimension is at least 2 times larger than the first dimension and the second dimension, preferably at least 5 times, yet more preferably at least 10 times. In embodiments, the line may have a ratio first on second dimension of from 1:3 to 3:1, preferably from 1:2 to 2:1, yet more preferably 1.3:1 to 1:1.3, such as 1:1. The line may, for example, be a wire or filament. The line, when perpendicular to the host substrate, may be referred to as a via. In embodiments, the line may be a coaxial line (i.e. it may comprise a central element and a mantle therearound).

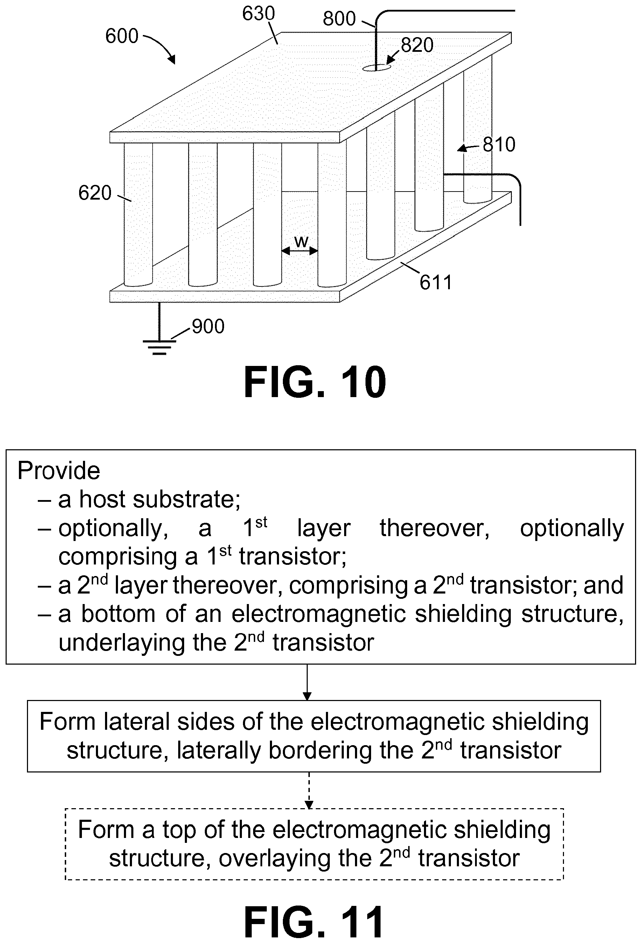

Any side of the electromagnetic shielding structure (i.e. each of the bottom, one or more lateral sides and, if present, top) may independently be an entity formed of a plurality of the shielding elements. The plurality of shielding elements may, for example, consist of from 2 to 1000 shielding elements, preferably from 5 to 100. In preferred embodiments, each side may independently consist of the entity formed of the plurality of the shielding elements. In embodiments, each side may independently comprise (e.g. consist of) a plurality of shielding elements of a plurality of natures. For example, a lateral side may comprise both a sheet and a line. Similarly, the bottom may comprise both an electrically conductive shielding element and a trap-rich shielding element. In more common embodiments, each side of the electromagnetic shielding structure may independently consist of one or more shielding elements of a single nature (e.g. a lateral side consisting of electrically conductive lines). In embodiments, a distance, such as an edge-to-edge distance (d; Fig. 10), between two parallel shielding elements may be from 10 nm to 1 µm. The distance between two parallel shielding elements is advantageously sufficiently small to allow an adequate shielding to be achieved; as the shielding quality of a side may typically decrease as the distance between shielding elements increases.

In embodiments, each of the one or more lateral sides may independently be angled with respect to the host substrate. In preferred embodiments, all of the one or more lateral sides may be angled with respect to the host substrate.

Preferably, each of the one or more lateral sides may independently be oriented such as to make an angle of from 60° to 120°, preferably from 75° to 105°, yet more preferably from 85° to 95°, preferably 90° with respect to the host substrate. In preferred embodiments, all of the one or more lateral sides may be oriented such as to make an angle of from 60° to 120°, preferably from 75° to 105°, yet more preferably from 85° to 95°, preferably 90° with respect to the host substrate. For instance, each of the one or more lateral sides may be perpendicular to the host substrate.

In embodiments, the one or more lateral sides may together laterally surround (i.e. border from all sides) the second transistor.

In a first type of embodiments, one or more lateral sides may each be an entity formed of a plurality of lines, preferably parallel with respect to each other. In preferred embodiments, each of the one or more lateral sides may each be an entity formed of a plurality of lines, preferably parallel with respect to each other. The plurality of lines may preferably be a plurality of electrically conductive lines. In preferred embodiments, the lines (e.g. vias) may be oriented such as to make an angle of from 60° to 120°, preferably from 75° to 105°, yet more preferably from 85° to 95°, preferably 90° with respect to the host substrate. For instance, each of the lines may be perpendicular to the host substrate. In other embodiments, the lines may be oriented such as to make an angle of from -30° to 30°, preferably from -15° to 15°, yet more preferably from -5° to 5°, preferably 0° with respect to the host substrate. For instance, the lines may be parallel to the host substrate.

In a second type of embodiments, one or more lateral sides may each be a sheet (e.g. a trench filled with conductive material, such as a buried power rail, or trap-rich material). It is also possible to form a lateral side from two of more parallel sheets. This is an alternative to increasing the thickness of a sheet.

In embodiments, the bottom and/or the top, if present, may be oriented such as to make an angle of from -30° to 30°, preferably from -15° to 15°, yet more preferably from -5° to 5°, with respect to the host substrate. For instance, the bottom and/or the top, if present, may be parallel to the host substrate. In preferred embodiments, the bottom or the top may be formed of a sheet. In preferred embodiments, each of the bottom, and if present the top, may be formed of a sheet. The top may preferably be formed of an electrically conductive sheet. The bottom may preferably be formed on an electrically conductive sheet or a trap-rich sheet. It is also possible to form a bottom or top from two of more parallel sheets. This is an alternative to increasing the thickness of a sheet.

In preferred embodiments, the bottom may consist of an electrically conductive sheet or a trap-rich sheet, the one or more lateral sides may each consist of an entity formed of a plurality of lines and the top, if present, may consist of an electrically conductive sheet.

In embodiments, a plurality, and preferably all, of:
the bottom,
the one or more lateral sides, and
if present, the top,
may be electrically coupled and preferably electrically connected. In embodiments, the electromagnetic shielding structure may be grounded. The electromagnetic shielding structure may be grounded by grounding a plurality, and preferably all, of the bottom, the one or more lateral sides and, if present, the top. Grounding a plurality, and preferably all, of the sides may comprise coupling a plurality of coupled sides to a ground. The ground is preferably a quiet ground. The electromagnetic shielding structure may preferably be grounded separately from other components (e.g. other semiconductor devices) in the integrated circuit. Electrically coupling the sides and/or grounding the electromagnetic shielding structure advantageously improves their electromagnetic shielding capabilities. Further improvements in shielding can be achieved by using a quiet ground and/or a dedicated ground separate from other elements in the integrated circuit.

In embodiments, the integrated circuit may further comprise:
one or more contact lines penetrating the electromagnetic shielding structure and contacting the second transistor (e.g. with another semiconductor device such as the first transistor).

Penetrating the electromagnetic shielding structure is typically performed by passing between two separate shielding elements or by passing through a hole in a shielding element.

In embodiments, any feature of any embodiment of the first aspect may be as correspondingly described for the second aspect and its embodiments.

In a second aspect, an example relates to a method for forming an integrated circuit comprising an electrochemically shielded second transistor, comprising the steps of: providing a structure comprising:
a host substrate,
optionally, a first layer overlying the host substrate, the first layer optionally comprising a first transistor,
a second layer overlaying the host substrate and the first layer, if present, the second layer comprising a second transistor, and
a bottom of an electromagnetic shielding structure, the bottom underlying the second transistor and comprised in the host substrate, the first layer, if present, or the second layer;
forming one or more lateral sides of the electromagnetic shielding structure, the lateral sides laterally bordering the second transistor; and
optionally, forming a top of the electromagnetic shielding structure, the top overlaying the second transistor;
wherein the bottom, each of the one or more lateral sides and, if present, the top each comprise at least one shielding element independently made up of either an electrically conductive material or a trap-rich material. A flow chart of this method is depicted in Fig. 11.

In some embodiments, providing the bottom of the electromagnetic shielding structure may comprise:
patterning one or more bottom cavities into the host substrate, the first layer, if present, or the second layer; and
filling the one or more bottom cavities with an electrically conductive material or a trap-rich material.

In embodiments, filling the one or more bottom cavities with an electrically conductive material may comprise using a damascene process. Providing the bottom of the electromagnetic shielding structure may advantageously be part of a first back-end-of-line process, e.g. the back-end-of-line process of the first layer. Providing the bottom of the electromagnetic shielding structure is advantageously performed at a temperature of 400 °C or below, such as to not damage other semiconductor devices already present in the integrated circuit.

In other embodiments, providing the bottom of the electromagnetic shielding structure may comprise forming a trap-rich layer. The trap-rich layer may, for example, be a trap-rich layer under a buried oxide layer in a SOI. Alternatively, the trap-rich layer may be a layer formed by ion implantation (e.g. deep ion implantation).

In a first type of embodiments, step a may comprise the substeps of:
providing the host substrate having the first layer thereon, the first layer comprising the bottom of the electromagnetic shielding structure; and
overlaying the first layer with the second layer.

In some embodiments of the first type, step a2 may comprise the further substeps of:
providing a further substrate having the second layer thereon;
bonding the second layer to the first layer, such that the first and the second layer are present between the host substrate and the further substrate;
removing at least part of the further substrate, such as to expose at least part of the second layer; and
forming the second transistor in the second layer, such that the second transistor overlays the bottom of the electromagnetic shielding structure.

In some other embodiments of the first type, step a2 may comprise the further substeps of:
providing a further substrate having the second layer thereon, the second layer comprising the second transistor; and
bonding the further substrate to the first layer, such that the first layer and the further substrate are present between the host substrate and the second layer and such that the second transistor overlays the bottom of the electromagnetic shielding structure.

In a second type of embodiments, step a may comprise the substeps of:
providing the host substrate having the first layer thereon;
providing a further substrate having the second layer thereon, the second layer comprising the second transistor, the second transistor being overlaid by the bottom of the electromagnetic shielding structure; and
bonding the second layer to the first layer, such that the first and the second layer are present between the host substrate and the further substrate.

Bonding the second layer to the first layer or bonding the further substrate to the first layer may comprise providing one or more bonding layers (e.g. an oxide bonding layer) therebetween.

In a third type of embodiments, step a may comprise the substeps of:
providing the host substrate having the second layer thereon;
forming the bottom of the electromagnetic shielding structure in the host substrate; and
forming the second transistor in the second layer, such that the second transistor overlays the bottom of the electromagnetic shielding structure.

In embodiments, forming the bottom of the electromagnetic shielding structure in the host substrate may comprise forming a trap-rich bottom in the host substrate. The trap-rich bottom may, for example, be a layer underlying a buried oxide layer in an SOI or a layer formed by ion implantation.

In embodiments, one or more of the lateral sides of the electromagnetic shielding structure may extend into the first layer or into the host substrate.

In embodiments, step b of forming one or more lateral sides of the electromagnetic shielding structure may comprise:
patterning one or more lateral openings into the second layer and optionally into the first layer so that these openings border laterally the second transistor; and
filling the one or more lateral openings with an electrically conductive material or a trap-rich material.

In embodiments, patterning the one or more lateral openings may comprise patterning one or more vias. The vias may be through-silicon vias (TSV). In embodiments, filling the one or more lateral openings with an electrically conductive material may comprise using a damascene process. Forming the one or more lateral sides of the electromagnetic shielding structure may advantageously be performed concurrently with forming one or more interlayer vias (e.g. vias coupling a semiconductor device in the first layer to a semiconductor device in the second layer). Forming the one or more lateral sides of the electromagnetic shielding structure is advantageously performed at a temperature of 400 °C or below, such as to not damage other semiconductor devices already present in the integrated circuit.

In embodiments, optional step c of forming the top of the electromagnetic shielding structure may comprise:
patterning one or more top cavities into the second layer and optionally into the first layer; and
filling the one or more top cavities with an electrically conductive material or a trap-rich material.

In embodiments, filling the one or more top cavities with an electrically conductive material may comprise using a damascene process. Forming the top of the electromagnetic shielding structure may advantageously be part of a second back-end-of-line process, e.g. the back-end-of-line process of the second layer. Forming the top of the electromagnetic shielding structure is advantageously performed at a temperature of 400 °C or below, such as to not damage other semiconductor devices already present in the integrated circuit.

In embodiments, filling the one or more lateral openings and the one or more top cavities may be performed concurrently, for example by using a dual-damascene process.

In embodiments, the electromagnetic shielding structure may be patterned with an opening for contact lines to pass therethrough.

In embodiments, any feature of any embodiment of the second aspect may be as correspondingly described for the first aspect and its embodiments.

The invention will now be described by a detailed description of several embodiments of the invention. It is clear that other embodiments of the invention can be configured according to the knowledge of the person skilled in the art without departing from the true technical teaching of the invention, the invention being limited only by the terms of the appended claims.

### Example 1: Comparison of different levels of electromagnetic shielding on the characteristics of a transistor

In order to measure the effect of different levels of electromagnetic shielding on a second transistor, simulations were performed using the EMX^{®} software developed by Integrand Software, Inc.

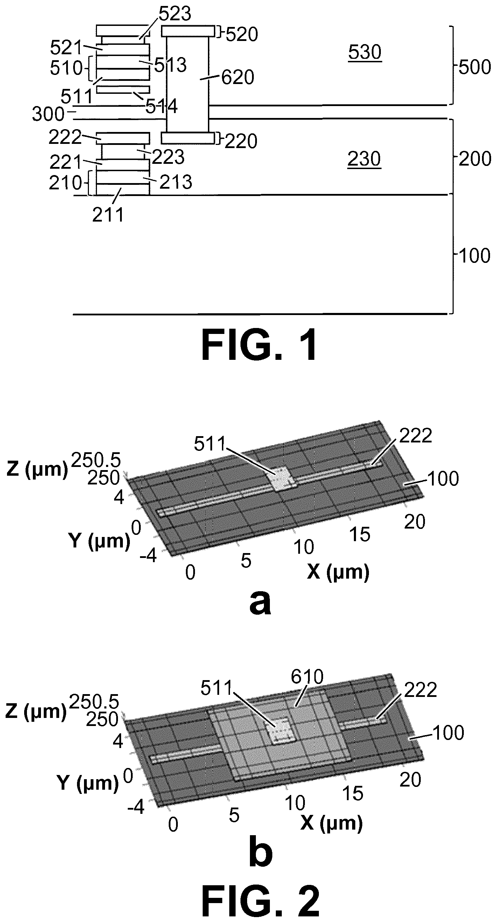

We now refer to Fig. 1, showing a schematic representation of a first integrated circuit (IC) programmed in the simulations. The first IC comprised a Si host substrate (100) and a first layer (200) thereon. An oxide bonding layer (300) bonds the first layer (200) to a second layer (500). The first layer (200) comprised a first transistor (210) in a first dielectric layer (230) and the second layer (500) comprised a second transistor (510) in a second dielectric layer (530). The first transistor (210) was represented by a Si first active layer (211) and a first gate layer (213) defining a channel in the first active layer (211). The first layer (200) further comprised a first contact trench layer (223) connected to the first gate layer (213) and first contact vias (221) coupling the first contact trench layer (223) to a first metal I layer (220), e.g. to a metal first interconnects (222) therein. The second transistor (510) was represented by a second active layer (511) and a second gate layer (513) defining a channel in the second active layer (511). An optional back-gate layer (514) was also present. The second layer (500) further comprised a second contact trench layer (523) connected to the second gate layer (513) and second contact vias (521) coupling the second contact trench layer (523) to a second metal I layer (520). The first (220) and second (520) metal I layers were coupled, through the bonding layer (300), by an interlayer via (620).

The characteristics of the different structures in the first IC, as used in the simulations, are summarized in the following table:

| | *Height (in µm)* | *Relative permittivity* | *Resistivity (in Ω*^{∗}*m)* | *Conductivity (in S*/*m)* |
|---|---|---|---|---|
| *Host substrate (100)* | 250 | 11.9 | 12.5 | 8 |
| *First dielectric layer (230)* | 0.6 | 3.9 | - | - |
| *Bonding layer (300)* | 0.1 | 4 | - | - |
| *Second dielectric layer (530)* | 3 | 3.9 | - | - |

| | *Height (in µm)* | *Sheet resistance (in Ω*/*sq)* | | |
|---|---|---|---|---|
| *First active layer (211)* | 0.086 | 16.9 | | |
| *First gate layer (213)* | 0.11 | 14.9 | | |
| *First contact trench layer (223)* | 0.09 | 0.22 | | |
| *First metal I layer (220)* | 0.09 | 0.2 | | |
| *Back-gate layer (514)* | 0.05 | 0.8 | | |
| *Second active layer (511)* | 0.086 | 16.9 | | |
| *Second gate layer (513)* | 0.11 | 16.9 | | |
| *Second contact trench layer (523)* | 0.09 | 0.22 | | |
| *Second metal I layer (520)* | 0.09 | 0.2 | | |

| | *Height (in µm)* | *Resistance (in Ω*/*via)* | | |
|---|---|---|---|---|
| *First contact via (221)* | 0.12 | 2.5 | | |
| *Second contact via (521)* | 0.01 | 2.5 | | |
| *Interlayer via (620)* | 0.7 | 10 | | |

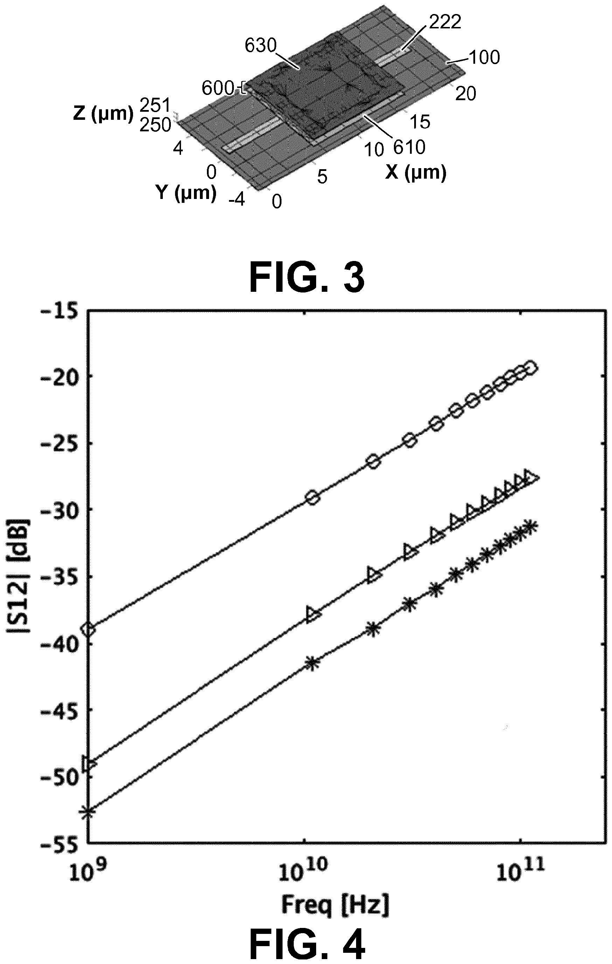

We now refer to Fig. 2, showing schematic representations of a perspective view of three ICs programmed in the simulations. Fig. 2a schematically depicts the first IC (corresponding to the IC schematically depicted in Fig. 1), showing the second active layer (511) overlaying a line (222) of the first metal I layer above the host substrate (100). Fig. 2b schematically depicts a second IC, differing from the first IC in that a level of electromagnetic shielding is provided by interjecting an electrically conductive sheet (610) between the line (222) of the first metal I layer and the second active layer (511). Fig. 3 schematically depicts a third IC, differing from the first and second IC in that a higher level of electromagnetic shielding is provided by enclosing the second active layer (511) in an electromagnetic shielding structure (600); the electromagnetic shielding structure (600) comprising the interjected electrically conductive sheet (610) as an bottom, a further electrically conductive sheet (630) above the second transistor (510) as an top and a plurality of interlayer vias (not visible in Fig. 3) coupling the top (630) to the bottom (610) and forming the sides of the electromagnetic shielding structure (600).

We now refer to Fig. 4, showing the simulation results for the first (circles), second (triangles) and third (asterisks) IC. The coupling between the line of the first metal I layer (representing an electromagnetic interference on the second transistor, i.e. an 'attack') and second active layer (representing the second transistor, which is to be protected) is measured by means of the transmission coefficient of the scattering matrix (S21 or S12, which are equal in this case since the circuit is symmetrical and reciprocal) in function of the frequency. It was observed that the isolation between the first metal I layer and the second transistor is improved by about 10 dB by the interposition of the conductive sheet in the second IC, compared to the first IC. Moreover, an additional improvement of about 4 dB was observed by enclosing the second transistor in the electromagnetic shielding structure in the third IC, compared to the second IC.

### Example 2: Forming an electromagnetic shielding structure around a second transistor, based on front-to-front bonding and layer transfer

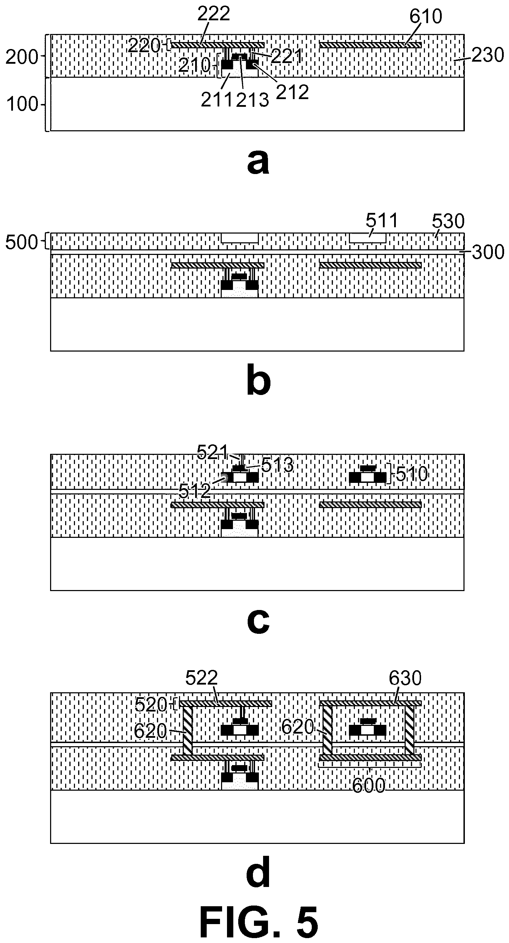

We now refer to Fig. 5, showing a schematic representation of vertical cross-sections for several steps in the formation of an IC, according to a first exemplary embodiment of the present invention.

We now refer to Fig. 5a. A first processed wafer is provided, having undergone a first front-end-of-line (FEOL) and back-end-of-line (BEOL) process. The first processed wafer comprises a Si host substrate (100) and a first layer (200) thereon; the first layer (200) comprising a first transistor (210) and a first metal I layer (220) in a SiO₂ first dielectric layer (230). The first transistor (210) comprises a first active layer (211), first source/drain electrodes (212) and a first gate electrode (213) defining a channel in the first active layer (211). First contact vias (221), of which only the ones to the first source/drain electrodes (212) are shown, couple the electrodes (212, 213) to metal first interconnects (222) in the first metal I layer (220). A first electrically conductive sheet (610) is further made, typically as part of the first metal I layer (220).

We now refer to Fig. 5b. A second layer (500) is transferred from a further substrate (not shown) onto the first layer (200), by bonding the second layer (500) to the first layer (200) (i.e. front-to-front bonding) using an oxide bonding layer (300) and subsequently etching away the further substrate. The second layer (500) can comprise a second active layer (511) embedded in a SiO₂ second dielectric layer (530) prior to bonding. Alternatively, the second layer (500) can comprise only the second active layer (511) prior to bonding; subsequently, after bonding, the second active layer (511) can be patterned and the second dielectric layer (530) can be provided therearound.

We now refer to Fig. 5c. A low-temperature second FEOL is performed on the second layer (500), thereby forming second transistors (510) by making second source/drain electrodes (512) (e.g. through doping of two opposing extremities of the second active layer (511)) and a second gate electrode (513) defining a channel in the second transistor (510). Furthermore, second contact vias (521), of which only one to a second gate electrode (513) is shown, contacting the electrodes (512, 513) are then fabricated.

We now refer to Fig. 5d. A second BEOL process is performed, forming interlayer vias (620) contacting the first metal I layer (220) and further forming a second metal I layer (520) (comprising e.g. metal second interconnects (522)) also contacting the interlayer vias (620). A second electrically conductive sheet (630) is further made, typically as part of the second metal I layer (520). An electromagnetic shielding structure (600) is thereby formed, comprising the first electrically conductive sheet (610) as the bottom, the second electrically conductive sheet (630) as top and a plurality of the interlayer vias (620) (typically parallel to one another) making up the sides. As shown in Fig. 5d, the electromagnetic shielding structure (600) may typically enclose at least one of the second transistors (510), while other second transistors (510) may remain unshielded. Additionally, one or more contact lines to the shielded second transistor (510) through the electromagnetic shielding structure (600) may typically be provided and the electromagnetic shielding structure (600) maybe grounded (see example 7).

### Example 3: Forming an electromagnetic shielding structure around a second transistor, based on back-to-front bonding

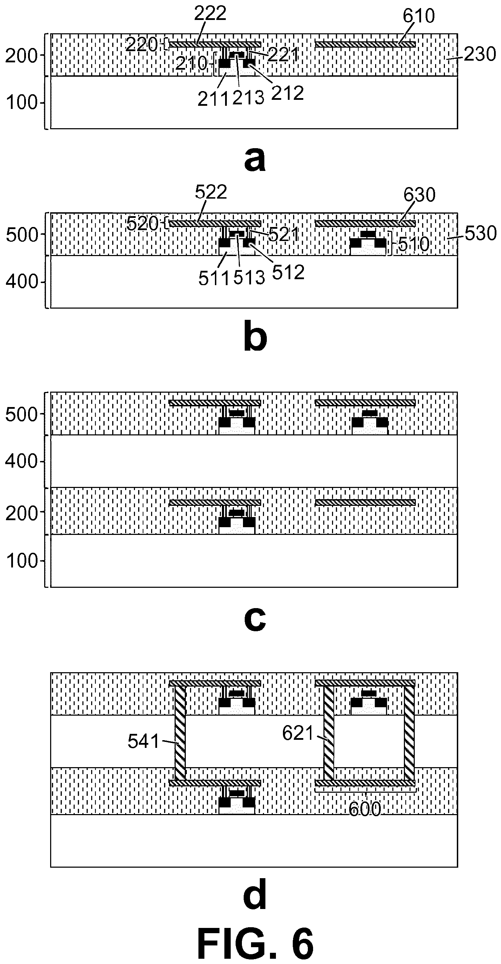

We now refer to Fig. 6, showing a schematic representation of vertical cross-sections for several steps in the formation of an TC, according to a second exemplary embodiment of the present invention.

We now refer to Fig. 6a. A first processed wafer is provided, having undergone a first front-end-of-line (FEOL) and back-end-of-line (BEOL) process. The first processed wafer comprises a Si host substrate (100) and a first layer (200) thereon; the first layer (200) comprising a first transistor (210) and a first metal I layer (220) in a SiO₂ first dielectric layer (230). The first transistor (210) comprises a first active layer (211), first source/drain electrodes (212) and a first gate electrode (213) defining a channel in the first active layer (211). First contact vias (221), of which only the ones to the first source/drain electrodes (212) are shown, couple the electrodes (212, 213) to metal first interconnects (222) in the first metal I layer (220). A first electrically conductive sheet (610) is further made, typically as part of the first metal I layer (220).

We now refer to Fig. 6b. A second processed wafer is provided, having undergone a second FEOL and BEOL process. The second processed wafer comprises a Si further substrate (400) and a second layer (500) thereon; the second layer (500) comprising a second transistor (510) and a second metal I layer (520) in a SiO2 second dielectric layer (530). The second transistor (510) comprises a second active layer (511), second source/drain electrodes (512) and a second gate electrode (513) defining a channel in the second active layer (511). Second contact vias (521), of which only the ones to the second source/drain electrodes (512) are shown, couple the electrodes (512, 513) to metal second interconnects (522) in the second metal I layer (520). A second electrically conductive sheet (630) is further made, typically as part of the second metal I layer (520).

We now refer to Fig. 6c. The second processed wafer is bonded to the first processed wafer by bonding the further substrate (400) to the first layer (200) (i.e. back-to-front bonding).

We now refer to Fig. 6d. Interlayer vias (621) in the form of through-silicon vias (TSV) are then fabricated, coupling the first metal I layer (220) and the second metal I layer (520). An electromagnetic shielding structure (600) is thus again formed, comprising the first electrically conductive sheet (610) as bottom, the second electrically conductive sheet (630) as top and a plurality of the TSV interlayer vias (621) (typically parallel to one another) making up the sides. As shown in Fig. 6d, the electromagnetic shielding structure (600) may typically enclose at least one of the second transistors (510), while other second transistors (510) may remain unshielded. Additionally, one or more contact lines to the shielded second transistor (510) through the electromagnetic shielding structure (600) may typically be provided and the electromagnetic shielding structure (600) may be grounded (see example 7).

### Example 4: Forming an electromagnetic shielding structure around a second transistor, based on front-to-front bonding

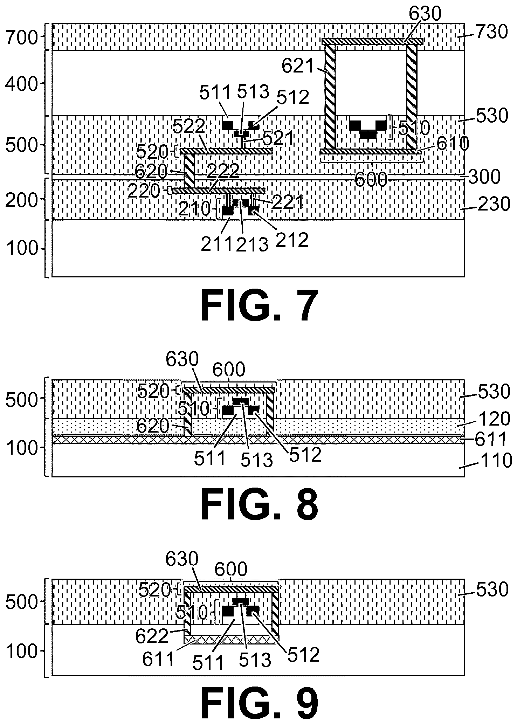

We now refer to Fig. 7, showing a schematic representation of a vertical cross-section of an IC, according to a third exemplary embodiment of the present invention. The method in this example combines elements from example 2 and example 3 presented above. It differs from example 2 in that the second transistors (510) and the bottom (610) of the electromagnetic shielding structure (600) are formed in the second layer (500) prior to bonding, and the further substrate (400) is not etched back. It differs from example 3 in that the two processed wafers are not bonded back-to-front, but front-to-front, and that the electrically conductive sheet in the second layer functions as the bottom (610) of the electromagnetic shielding structure (600).

A first processed wafer is provided, having undergone a first front-end-of-line (FEOL) and back-end-of-line (BEOL) process. The first processed wafer comprises a Si host substrate (100) and a first layer (200) thereon; the first layer (200) comprising a first transistor (210) and a first metal I layer (220) in a SiO₂ first dielectric layer (230). The first transistor (210) comprises a first active layer (211), first source/drain electrodes (212) and a first gate electrode (213) defining a channel in the first active layer (211). First contact vias (221), of which only the ones to the first source/drain electrodes (212) are shown, couple the electrodes (212, 213) to metal first interconnects (222) in the first metal I layer (220).

A second processed wafer is provided, having undergone a second FEOL and BEOL process. The second processed wafer comprises a Si further substrate (400) and a second layer (500) thereon; the second layer (500) comprising a second transistor (510) and a second metal I layer (520) in a SiO₂ second dielectric layer (530). The second transistor (510) comprises a second active layer (511), second source/drain electrodes (512) and a second gate electrode (513) defining a channel in the second active layer (511). Second contact vias (521), of which only one to a second gate electrode (513) is shown, couple the electrodes (512, 513) to metal second interconnects (522) in the second metal I layer (520). A first electrically conductive sheet (610) is further made, typically as part of the second metal I layer (520).

A third layer (700) is provided on top of the further substrate (400). The third layer (700) comprises a second electrically conductive sheet (630) in a third SiO₂ dielectric layer (730). Interlayer vias (620) coupling the first electrically conductive sheet (610) to the electrically conductive sheet (630) are then fabricated. An electromagnetic shielding structure (600) is thereby formed, comprising the first electrically conductive sheet (610) as bottom, the second electrically conductive sheet (630) as top and the interlayer vias (620) (typically parallel to one another) making up the sides. Additionally, one or more contact lines to the shielded second transistor (510) through the electromagnetic shielding structure (600) may typically be provided and the electromagnetic shielding structure (600) may be grounded (see example 7). As the electromagnetic shielding structure (600) encloses a portion of the further substrate (400), some unshielded electromagnetic interference between the portion and the second transistor (510) may remain.

### Example 5: Forming an electromagnetic shielding structure around a second transistor, using a trap-rich layer in an SOI

We now refer to Fig. 8, showing a schematic representation of a vertical cross-section of an IC, according to a fourth exemplary embodiment of the present invention.

An SOI is provided comprising a second layer (500) on a host substrate (100). The host substrate (100) comprises a Si layer (110), a trap-rich sheet (611) thereon and a buried oxide layer (120) overlaying the trap-rich sheet (611). A second transistor (510) and a metal I layer (520) are formed in a SiO₂ second dielectric layer (530) of the second layer (500). The second transistor (510) comprises a second active layer (511), second source/drain electrodes (512) and a second gate electrode (513) defining a channel in the second active layer (511). An electrically conductive sheet (630) is further made, typically as part of the metal I layer (520). Vias (620) connecting the trap-rich sheet (611) to the electrically conductive sheet (630) are then fabricated. An electromagnetic shielding structure (600) is thereby formed, comprising the trap-rich sheet (611) as bottom, the electrically conductive sheet (630) as top and the vias (620) (typically parallel to one another) making up the sides. Additionally, one or more contact lines to the shielded second transistor (510) through the electromagnetic shielding structure (600) may typically be provided and the electromagnetic shielding structure (600) may be grounded (see example 7).

### Example 6: Forming an electromagnetic shielding structure around a second transistor, based deep implantation and buried power rails

We now refer to Fig. 9, showing a schematic representation of a vertical cross-section of an IC, according to a fifth exemplary embodiment of the present invention.

A second layer (500) is provided on a Si host substrate (100). Using deep implanting, a trap-rich sheet (611) is formed in the host substrate (100). Buried power rails (622) are formed by etching a trench and filling the trench with an electrically conductive material. A second transistor (510), and a metal I layer (520) is subsequently formed in a SiO₂ second dielectric layer (530) of the second layer (500). The second transistor (510) comprises a second active layer (511), second source/drain electrodes (512) and a second gate electrode (513) defining a channel in the second active layer (511). An electrically conductive sheet (630) is further made, typically as part of the metal I layer (520). An electromagnetic shielding structure (600) is thereby formed, comprising the trap-rich sheet (611) as the bottom, the electrically conductive sheet (630) as top and the buried power rails (622) making up the sides. Additionally, one or more contact lines to the shielded second transistor (510) through the electromagnetic shielding structure (600) may typically be provided and the electromagnetic shielding structure (600) may be grounded (see example 7). As the electromagnetic shielding structure (600) encloses a portion of the host substrate (100), some unshielded electromagnetic interference between the portion and the second transistor (510) may remain.

### Example 7: Contact lines through the electromagnetic shielding structure and grounding of the electromagnetic shielding structure

We now refer to Fig. 10, showing contact lines (800), e.g. comprising one or more of the second contact vias and/or one or more of the second interconnects, to the shielded second transistor (not shown in Fig. 10), which typically penetrate the electromagnetic shielding structure (600). This may, for example, occur through a gap (810) in between two vias (620), or an opening (820) may alternatively be provided in the top (630) or bottom (610) and a contact line may pass therethrough.

Additionally, the electromagnetic shielding structure (600) is typically coupled to a ground (900) in order to improve its shielding capabilities.

## Claims

1. An integrated circuit, comprising:
i. a host substrate (100);
ii. optionally, a first layer (200) overlaying the host substrate (100), the first layer (200) optionally comprising a first transistor (210);
iii. a second layer (500) overlaying the host substrate (100) and the first layer (200), if present, the second layer (500) comprising a second transistor (510); and
iv. an electromagnetic shielding structure (600) shielding the second transistor (510) from electromagnetic fields, comprising
- a bottom (610, 611) underlying the second transistor (510) and comprised in the host substrate (100), the first layer (200), if present, or the second layer (500),
- one or more lateral sides (620, 621, 622) laterally bordering the second transistor (510), and
- optionally, a top (630) overlaying the second transistor (510);
wherein the bottom (610, 611), each of the one or more lateral sides (620, 621, 622) and, if present, the top (630) each comprise at least one shielding element independently made up of either an electrically conductive material or a trap-rich material selected from trap-rich polycrystalline silicon and trap-rich amorphous silicon, the trap rich material having a trap density of at least 10²² cm⁻³,
**characterized in that** the bottom (610, 611), each of the one or more lateral sides (620, 621, 622) and, if present, the top (630) do not each comprise at least one shielding element made up of an electrically conductive material.

2. The integrated circuit according to claim 1, wherein the electrically conductive material has a conductivity of at least 1 × 10⁵ S/m.

3. The integrated circuit according to claim 1 or claim 2, wherein each of the shielding elements is independently selected from a sheet and a line.

4. The integrated circuit according to claim 3, wherein each of the one or more lateral sides (620, 621, 622) is an entity formed of a plurality of the shielding elements.

5. The integrated circuit according to claim 4, wherein a distance (d) between two parallel shielding elements is from 10 nm to 1 µm.

6. The integrated circuit according to any of claims 3 to 5, wherein each of the bottom (610, 611), and if present the top (630), is formed of a sheet.

7. The integrated circuit according to any of the preceding claims, wherein a plurality, and preferably all, of:
- the bottom (610, 611),
- the one or more lateral sides (620, 621, 622), and
- if present, the top (630),
are electrically coupled.

8. The integrated circuit according to any of the preceding claims, wherein the electromagnetic shielding structure (600) is grounded.

9. The integrated circuit according to any of the previous claims, wherein a distance between the second transistor (510) and each of:
- the bottom (610, 611),
- the lateral sides (620, 621, 622), and
- if present, the top (630),
is smaller than 10 µm.

10. The integrated circuit according to any of the previous claims, wherein the second transistor (510) is adapted for radio frequency, logic or mixed-signal applications.

11. The integrated circuit according to claim 10, wherein the second transistor (510) is a high-electron-mobility-transistor.

12. The integrated circuit according to any of the previous claims, further comprising:
v. one or more contact lines penetrating the electromagnetic shielding structure (600) and contacting the second transistor (510).

13. A method for forming an integrated circuit comprising an electromagnetically shielded second transistor (510), comprising the steps of:
a. providing a structure comprising:
- a host substrate (100),
- optionally, a first layer (200) overlaying the host substrate (100), the first layer (200) optionally comprising a first transistor (210),
- a second layer (500) overlaying the host substrate (100) and the first layer (200), if present, the second layer (500) comprising a second transistor (510), and
- a bottom (610, 611) of an electromagnetic shielding structure (600), the bottom (610, 611) underlying the second transistor (510) and comprised in the host substrate (100), the first layer (200), if present, or the second layer (500);
b. forming one or more lateral sides (620, 621, 622) of the electromagnetic shielding structure (600), the lateral sides (620, 621, 622) laterally bordering the second transistor (510); and
c. optionally, forming a top (630) of the electromagnetic shielding structure (600), the top overlaying the second transistor (510);
wherein the bottom (610, 611), each of the one or more lateral sides (620, 621, 622) and, if present, the top (630) each comprise at least one shielding element independently made up of either an electrically conductive material or a trap-rich material selected from trap-rich polycrystalline silicon and trap-rich amorphous silicon, the trap rich material having a trap density of at least 10²² cm⁻³,
**characterized in that** the bottom (610, 611), each of the one or more lateral sides (620, 621, 622) and, if present, the top (630) do not each comprise at least one shielding element made up of an electrically conductive material.

14. The method according to claim 13, wherein step a comprises the substeps of:
a1. providing the host substrate (100) having the first layer (200) thereon, the first layer (200) comprising the bottom (610) of the electromagnetic shielding structure (600); and
a2. overlaying the first layer (200) with the second layer (500).

15. The method according to claim 13, wherein step a comprises the substeps of:
a'1. providing the host substrate (100) having the first layer (200) thereon;
a'2. providing a further substrate (400) having the second layer (500) thereon, the second layer (500) comprising the second transistor (510), the second transistor (510) being overlaid by the bottom (610) of the electromagnetic shielding structure (600); and
a'3. bonding the second layer (500) to the first layer (200), such that the first (200) and the second layer (500) are present between the host substrate (100) and the further substrate (400).

16. The method according to claim 13, wherein step a comprises the substeps of:
a"1. providing the host substrate (100) having the second layer (500) thereon;
a"2. forming the bottom (611) of the electromagnetic shielding structure (600) in the host substrate (100); and
a"3. forming the second transistor (510) in the second layer (500), such that the second transistor (510) overlays the bottom of the electromagnetic shielding structure (600).

## Patentansprüche

1. Eine integrierte Schaltung, umfassend:
i.- ein Hostsubstrat (100);
ii.- optional eine erste Schicht (200), die über dem Hostsubstrat (100) liegt, wobei die erste Schicht (200) optional einen ersten Transistor (210) umfasst;
iii.- eine zweite Schicht (500), die über dem Hostsubstrat (100) und der ersten Schicht (200) falls vorhanden, liegt, wobei die zweite Schicht (500) einen zweiten Transistor (510) umfasst; und
vi.- eine elektromagnetische Abschirmungsstruktur (600), die den zweiten Transistor (510) von elektromagnetischen Feldern abschirmt, umfassend
- einen Boden (610, 611), der unter dem zweiten Transistor (510) liegt und in dem Hostsubstrat (100), der ersten Schicht (200), falls vorhanden, oder der zweiten Schicht (500) umfasst ist,
- eine oder mehrere laterale Seiten (620, 621, 622), die den zweiten Transistor (510) lateral begrenzen, und
- optional eine Deckschicht (630), die über dem zweiten Transistor (510) liegt;
wobei der Boden (610, 611), jede der einen oder mehreren lateralen Seiten (620, 621, 622) und, falls vorhanden, die Deckschicht (630) jeweils mindestens ein Abschirmungselement umfassen, das unabhängig aus entweder einem elektrisch leitfähigen Material oder einem haftstellenreichen Material, das aus haftstellenreichem polykristallinem Silizium und haftstellenreichem amorphen Silizium ausgewählt ist, aufgebaut ist, wobei das haftstellenreiche Material eine Haftstellendichte von mindestens 10²²cm⁻³ aufweist,
**dadurch gekennzeichnet, dass** der Boden (610, 611), jede der einen oder mehreren lateralen Seiten (620, 621, 622) und, falls vorhanden, die Deckschicht (630) nicht jeweils mindestens ein Abschirmungselement umfassen, das aus einem elektrisch leitfähigen Material aufgebaut ist.

2. Die integrierte Schaltung nach Anspruch 1, wobei das elektrisch leitfähige Material eine Leitfähigkeit von mindestens 1 × 10⁵ S/m aufweist.

3. Die integrierte Schaltung nach Anspruch 1 oder Anspruch 2, wobei jedes der Abschirmungselemente unabhängig aus einem Blatt und einem Strang ausgewählt ist.

4. Die integrierte Schaltung nach Anspruch 3, wobei jede der einen oder mehreren lateralen Seiten (620, 621, 622) eine Einheit ist, die aus einer Vielzahl von Abschirmungselementen gebildet ist.

5. Die integrierte Schaltung nach Anspruch 4, wobei eine Distanz (d) zwischen zwei parallelen Abschirmungselementen 10 nm bis 1 µm beträgt.

6. Die integrierte Schaltung nach einem der Ansprüche 3 bis 5, wobei jedes von dem Boden (610, 611) und, falls vorhanden, der Deckschicht (630) aus einem Blatt gebildet ist.

7. Die integrierte Schaltung nach einem der vorstehenden Ansprüche, wobei eine Vielzahl und vorzugsweise alle von:
- dem Boden (610, 611),
- der einen oder mehreren lateralen Seiten (620, 621, 622) und
- falls vorhanden, der Deckschicht (630) elektrisch gekoppelt sind.

8. Die integrierte Schaltung nach einem der vorstehenden Ansprüche, wobei die elektromagnetische Abschirmungsstruktur (600) geerdet ist.

9. Die integrierte Schaltung nach einem der vorstehenden Ansprüche, wobei eine Distanz zwischen dem zweiten Transistor (510) und jedem von:
- dem Boden (610, 611),
- der einen oder mehreren lateralen Seiten (620, 621, 622) und
- falls vorhanden, der Deckschicht (630) kleiner als 10 µm ist.

10. Die integrierte Schaltung nach einem der vorstehenden Ansprüche, wobei der zweite Transistor (510) für Funkfrequenz-, logische oder Mischsignalanwendungen angepasst ist.

11. Die integrierte Schaltung nach einem der vorstehenden Ansprüche, wobei der zweite Transistor (510) ein Hochelektronenmobilitätstransistor ist.

12. Die integrierte Schaltung nach einem der vorstehenden Ansprüche, weiter umfassend:
v. eine oder mehrere Kontaktleitungen, die die elektromagnetische Abschirmungsstruktur (600) durchdringen und den zweiten Transistor (510) kontaktieren.

13. Ein Verfahren zum Bilden einer integrierten Schaltung, umfassend einen elektromagnetisch abgeschirmten zweiten Transistor (510), umfassend die folgenden Schritte:
a) Bereitstellen einer Struktur, umfassend:
- ein Hostsubstrat (100),
- optional eine erste Schicht (200), die über dem Hostsubstrat (100) liegt, wobei die erste Schicht (200) optional einen ersten Transistor (210) umfasst,
- eine zweite Schicht (500), die über dem Hostsubstrat (100) und der ersten Schicht (200) falls vorhanden, liegt, wobei die zweite Schicht (500) einen zweiten Transistor (510) umfasst, und
- einen Boden (610, 611) einer elektromagnetischen Abschirmungsstruktur (600), wobei der Boden (610, 611) unter dem zweiten Transistor (510) liegt und in dem Hostsubstrat (100), der ersten Schicht (200), falls vorhanden, oder der zweiten Schicht (500) umfasst ist;
b) Bilden einer oder mehrerer lateraler Seiten (620, 621, 622) der elektromagnetischen Abschirmungsstruktur (600), wobei die lateralen Seiten (620, 621, 622) den zweiten Transistor (510) lateral begrenzen; und
c) optional Bilden einer Deckschicht (630) der elektromagnetischen Abschirmungsstruktur (600), wobei die Deckschicht über dem zweiten Transistor (510) liegt;
wobei der Boden (610, 611), jede der einen oder mehreren lateralen Seiten (620, 621, 622) und, falls vorhanden, die Deckschicht (630) jeweils mindestens ein Abschirmungselement umfassen, das unabhängig aus entweder einem elektrisch leitfähigen Material oder einem haftstellenreichen Material, das aus haftstellenreichem polykristallinem Silizium und haftstellenreichem amorphen Silizium ausgewählt ist, aufgebaut ist, wobei das haftstellenreiche Material eine Haftstellendichte von mindestens 10²²cm⁻³ aufweist;
**dadurch gekennzeichnet, dass** der Boden (610, 611), jede der einen oder mehreren lateralen Seiten (620, 621, 622) und, falls vorhanden, die Deckschicht (630) nicht jeweils mindestens ein Abschirmungselement umfassen, das aus einem elektrisch leitfähigen Material aufgebaut ist.

14. Das Verfahren nach Anspruch 13, wobei Schritt a die folgenden Teilschritte umfasst:
a1.- Bereitstellen des Hostsubstrats (100) mit der ersten Schicht (200) darauf, wobei die erste Schicht (200) den Boden (610) der elektromagnetischen Abschirmungsstruktur (600) umfasst; und
a2.- Auflegen der zweiten Schicht (500) auf die erste Schicht (200).

15. Das Verfahren nach Anspruch 13, wobei Schritt a die folgenden Teilschritte umfasst:
a'1.- Bereitstellen des Hostsubstrats (100) mit der ersten Schicht (200) darauf;
a'2.- Bereitstellen eines weiteren Substrats (400) mit der zweiten Schicht (500) darauf, wobei die zweite Schicht (500) den zweiten Transistor (510) umfasst, wobei auf dem zweiten Transistor (510) der Boden (610) der elektromagnetischen Abschirmungsstruktur (600) liegt; und
a'3.- Binden der zweiten Schicht (500) an die erste Schicht (200), sodass die erste (200) und die zweite Schicht (500) zwischen dem Hostsubstrat (100) und dem weiteren Substrat (400) vorhanden sind.

16. Das Verfahren nach Anspruch 13, wobei Schritt a die folgenden Teilschritte umfasst:
a"1.- Bereitstellen des Hostsubstrats (100) mit der zweiten Schicht (500) darauf;
a"2.- Bilden des Bodens (611) der elektromagnetischen Abschirmungsstruktur (600) in dem Hostsubstrat (100); und
a"3.- Bilden des zweiten Transistors (510) in der zweiten Schicht (500), sodass der zweite Transistor (510) über dem Boden der elektromagnetischen Abschirmungsstruktur (600) liegt.

## Revendications

1. Un circuit intégré, comprenant :
i. un substrat hôte (100) ;
ii. optionnellement, une première couche (200) recouvrant le substrat hôte (100), la première couche (200) comprenant optionnellement un premier transistor (210) ;
iii. une seconde couche (500) recouvrant le substrat hôte (100) et la première couche (200), si présente, la seconde couche (500) comprenant un second transistor (510) ; et
iv. une structure de blindage électromagnétique (600) blindant le second transistor (510) vis-à-vis de champs électromagnétiques, comprenant
- un fond (610, 611) sous-jacent au second transistor (510) et compris dans le substrat hôte (100), la première couche (200), si présente, ou la seconde couche (500),
- un ou plusieurs côtés latéraux (620, 621, 622) délimitant latéralement le second transistor (510), et
- optionnellement, un dessus (630) recouvrant le second transistor (510) ;
dans lequel le fond (610, 611), chacun des un ou plusieurs côtés latéraux (620, 621, 622) et, si présent, le dessus (630) comprennent chacun au moins un élément de blindage indépendamment composé d'un matériau électroconducteur ou d'un matériau riche en pièges sélectionné parmi du silicium polycristallin riche en pièges et du silicium amorphe riche en pièges, le matériau riche en pièges présentant une densité de pièges d'au moins 10²² cm⁻³,
**caractérisé en ce que** le fond (610, 611), chacun des uns ou plusieurs côtés latéraux (620, 621, 622) et, si présent, le dessus (630) ne comprennent pas chacun au moins un élément de blindage composé d'un matériau électroconducteur.

2. Le circuit intégré selon la revendication 1, dans lequel le matériau électroconducteur présente une conductivité d'au moins 1 × 10⁵ S/m.

3. Le circuit intégré selon la revendication 1 ou la revendication 2, dans lequel chacun des éléments de blindage est indépendamment sélectionné parmi une feuille et une ligne.

4. Le circuit intégré selon la revendication 3, dans lequel chacun des un ou plusieurs côtés latéraux (620, 621, 622) est une entité formée d'une pluralité des éléments de blindage.

5. Le circuit intégré selon la revendication 4, dans lequel une distance (d) entre deux éléments de blindage parallèles fait de 10 nm à 1 µm.

6. Le circuit intégré selon l'une quelconque des revendications 3 à 5, dans lequel chacun du fond (610, 611), et si présent du dessus (630), est formé d'une feuille.

7. Le circuit intégré selon l'une quelconque des revendications précédentes, dans lequel une pluralité, et de préférence la totalité :
- du fond (610, 611),
- des un ou plusieurs côtés latéraux (620, 621, 622), et
- si présent, du dessus (630),
sont électriquement couplés.

8. Le circuit intégré selon l'une quelconque des revendications précédentes, dans lequel la structure de blindage électromagnétique (600) est mise à la terre.

9. Le circuit intégré selon l'une quelconque des revendications précédentes, dans lequel une distance entre le second transistor (510) et chacun :
- du fond (610, 611),
- des un ou plusieurs côtés latéraux (620, 621, 622), et
- si présent, du dessus (630),
est inférieure à 10 µm.

10. Le circuit intégré selon l'une quelconque des revendications précédentes, dans lequel le second transistor (510) est adapté pour des applications de fréquence radio, logique ou signaux mixtes.

11. Le circuit intégré selon la revendication 10, dans lequel le second transistor (510) est un transistor à mobilité d'électrons élevée.

12. Le circuit intégré selon l'une quelconque des revendications précédentes, comprenant en outre :
v. une ou plusieurs lignes de contact pénétrant dans la structure de blindage électromagnétique (600) et étant en contact avec le second transistor (510).

13. Un procédé de formation d'un circuit intégré comprenant un second transistor blindé électromagnétiquement (510), comprenant les étapes consistant à :
a. fournir une structure comprenant :
- un substrat hôte (100),
- optionnellement, une première couche (200) recouvrant le substrat hôte (100), la première couche (200) comprenant optionnellement un premier transistor (210),
- une seconde couche (500) recouvrant le substrat hôte (100) et la première couche (200), si présente, la seconde couche (500) comprenant un second transistor (510), et
- un fond (610, 611) d'une structure de blindage électromagnétique (600), le fond (610, 611) étant sous-jacent au second transistor (510) et compris dans le substrat hôte (100), la première couche (200), si présente, ou la seconde couche (500) ;
b. former un ou plusieurs côtés latéraux (620, 621, 622) de la structure de blindage électromagnétique (600), les côtés latéraux (620, 621, 622) délimitant latéralement le second transistor (510) ; et
c. optionnellement, former un dessus (630) de la structure de blindage électromagnétique (600), le dessus recouvrant le second transistor (510) ;
dans lequel le fond (610, 611), chacun des un ou plusieurs côtés latéraux (620, 621, 622) et, si présent, le dessus (630) comprennent chacun au moins un élément de blindage indépendamment composé d'un matériau électroconducteur ou d'un matériau riche en pièges sélectionné parmi du silicium polycristallin riche en pièges et du silicium amorphe riche en pièges, le matériau riche en pièges présentant une densité de pièges d'au moins 10²² cm⁻³,
**caractérisé en ce que** le fond (610, 611), chacun des uns ou plusieurs côtés latéraux (620, 621, 622) et, si présent, le dessus (630) ne comprennent pas chacun au moins un élément de blindage composé d'un matériau électroconducteur.

14. Le procédé selon la revendication 13, dans lequel l'étape a comprend les sous-étapes consistant à :
a1. fournir le substrat hôte (100) présentant la première couche (200) sur celui-ci, la première couche (200) comprenant le fond (610) de la structure de blindage électromagnétique (600) ; et
a2. recouvrir la première couche (200) par la seconde couche (500).

15. Le procédé selon la revendication 13, dans lequel l'étape a comprend les sous-étapes consistant à :
a'1. fournir le substrat hôte (100) présentant la première couche (200) sur celui-ci ;
a'2. fournir un substrat supplémentaire (400) présentant la seconde couche (500) sur celui-ci, la seconde couche (500) comprenant le second transistor (510), le second transistor (510) étant recouvert par le fond (610) de la structure de blindage électromagnétique (600) ; et
a'3. lier la seconde couche (500) à la première couche (200), de telle sorte que la première (200) et la seconde (500) couche sont présentes entre le substrat hôte (100) et le substrat supplémentaire (400).

16. Le procédé selon la revendication 13, dans lequel l'étape a comprend les sous-étapes consistant à :
a''1. fournir le substrat hôte (100) présentant la seconde couche (500) sur celui-ci ;
a''2. former le fond (611) de la structure de blindage électromagnétique (600) dans le substrat hôte (100) ; et
a''3. former le second transistor (510) dans la seconde couche (500), de telle sorte que le second transistor (510) recouvre le fond de la structure de blindage électromagnétique (600).
